Europäisches Patentamt

European Patent Office

Office européen des brevets

(19)

(11) Numéro de publication: **0 004 815**
**B1**

(12) **FASCICULE DE BREVET EUROPEEN**

(45) Date de publication du fascicule du brevet: **12.05.82**

(51) Int. Cl.³: **H 03 G 3/20, H 04 B 9/00**

(21) Numéro de dépôt: **79400206.3**

(22) Date de dépôt: **30.03.79**

(54) **Système de transmission de signaux électriques à liaison optique et dispositif de contrôle automatique du gain d'une voie de réception connectée à cette liaison optique.**

(30) Priorité: **11.04.78 FR 7810611**

(43) Date de publication de la demande:
**17.10.79 Bulletin 79/21**

(45) Mention de la délivrance du brevet:
**12.05.82 Bulletin 82/19**

(84) Etats contractants désignés:
**CH DE GB IT NL SE**

(56) Documents cités:
**DE - A - 2 521 091**
**FR - A - 2 361 022**

**IEEE TRANSACTIONS ON INSTRUMENTATION AND MEASUREMENT, vol. IM—24, n° 3, septembre 1975, New York**
**J. C. BLACKBURN: "A 120-MHz bandwidth linear signal transmission system using fiber optics" pages 230—232.**

(73) Titulaire: **THOMSON-CSF**
**173, Boulevard Haussmann**
**F-75360 Paris Cedex 08 (FR)**

(72) Inventeur: **Eumurian, Grégoire**
**"THOMSON-CSF" - SCPI 173, bld Haussmann**
**F-75360 Paris Cedex 08 (FR)**

(74) Mandataire: **Eisenbeth, Jacques Pierre et al,**
**"THOMSON-CSF" - SCPI 173, bld Haussmann**
**F-75360 Paris Cedex 08 (FR)**

Système de transmission de signaux électriques à liaison optique et dispositif de contrôle
automatique du gain d'une voie de réception connectée à cette liaison optique

La présente invention concerne un système de transmission de signaux électriqes comportant une liaison optique et un dispositif de contrôle automatique du gain d'une voie de réception connectée à la sortie de cette liaison optique.

Le système de transmission est plus particulièrement susceptible d'être soumis à des signaux de forte puissance.

Il est des domaines, principalement celui connu sous le nom d'électronique rapide dans lequel on est amené à traiter après qu'ils aient été détectés puis transmis, des signaux impulsionnels pouvant être de très faible durée, de récurrence également très faible et dont la forme initiale peut ne pas être connue, mais quil faut néanmoins pouvoir reconstituer avec une certaine précision lors du traitement. Ceci peut être le cas dans des transmissions de signaux numériques de l'ordre de la centaine de mègabits à très large bande passante de l'ordre par exemple de 500 Mcs.

Dans de telles transmissions, les signaux captés sont transformés en signaux optiques à l'aide d'émetteurs optiques rapides du type diode laser, permettant d'obtenir des liaisons à large bande pouvant aller de 100 Mégahertz à un Gigahertz environ. Ces liaisons optiques sont faites par des fibres optiques qui présentent par rapport à des liaisons électriques l'avantage d'un isolement galvanique et d'une bande passante étendue. Par contre ces liaisons par fibres optiques présentent l'inconvénient d'apporter une atténuation aux signaux transmis pouvant varier notablement au cours de la transmission. Ceci est dû au fait que les connecteurs optiques utilisés sont extrêmement sensibles aux tolérances mécaniques et à la poussière et également au fait que certaines fibres optiques, de type multibrins, peuvent avoir un nombre variable de fibres cassées qui atténuent encore la transmission de la lumière. A ces variations de niveau, viennent s'ajouter les variations produites par les éléments d'émission et de réception.

L'élément d'émission est le transducteur qui recevant du capteur le signal à traiter, le transforme en un signal optique. D'une façon générale, cet élément d'émission peut être un laser solide ou une diode électroluminescente qui présente une pente de conversion courant-puissance optique variable dans le temps. Le récepteur optique, recevant les signaux transmis par les fibres constituant la liaison optique émetteur-récepteur, peur utiliser deux types de diodes, PIN ou à avalanche. Les diodes PIN sont stables en température et en fonction de la tension de polarisation. Les photodiodes à avalanches qui présentent une sensibilité environ 100 fois plus grande à la lumière, sont en revanche très sensibles aux variations de température et de tension.

Cette revue des inconvénients présentés par les systèmes de transmission utilisant des liaisons optiques opposés aux avantages que comporte l'utilisation de telles liaisons, impose que l'on se soucie de la stabilité des systèmes. Dans les systèmes les éléments d'émission et de réception sont généralement stabilisés par des boucles de régulation. Les variations de niveau encore existantes proviennent alors presque exclusivement des liaisons optiques.

Suivant l'art antérieur, voulant connaître avec une plus ou moins bonne précision suivant le cas, les pertes subies par les signaux dans la liaison optique, pour pouvoir, en jouant sur le gain, rétablir le niveau du signal à sa valeur à l'entrée de la liaison, on superpose au signal à traiter appelé signal utile, un signal pilote de niveau déterminé et connue, situé en dehors de la bande passante du signal utile. Les atténuations subies par le signal pilote étant identiques à celles subies par le signal utile il est possible à la réception de rétablir le niveau du signal utile.

A la réception le signal pilote est extrait du signal composite qui comprend le signal utile et le signal pilote et après détection commande un dispositif à gain variable fonctionnant en numérique.

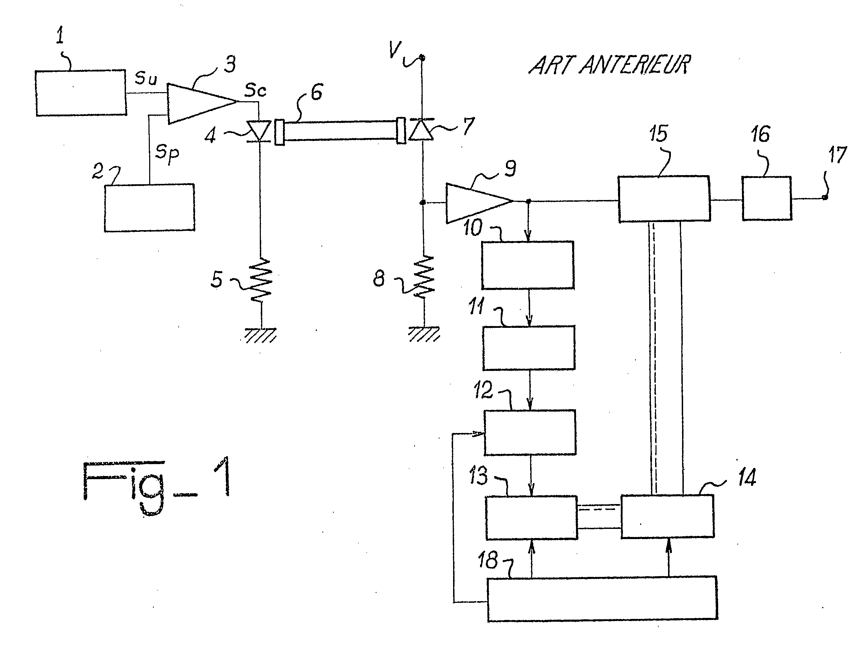

La figure 1 rappelle de façon schématique un tel dispositif de l'art antérieur. Le capteur 1 reçoit le signal utile qui de façon générale est de faible durée et de niveau inconnu et le transmet sous forme électrique à un dispositif modulateur 3 qui reçoit de la source 2, le signal pilote ayant une forme et une amplitude fixe. Le dispositif de modulation superpose le signal utile Su et le signal pilote Sp et délivre un signal composite Sc qui frappe par exemple une diode électroluminescente 4 en série avec une résistance 5. Cette diode transforme le signal composite Sc électrique en un signal optique qui est transmis à la partie réception du dispositif à travers une liaison optique 6. La sortie de cette liaison optique débouche sur un transducteur de réception, une photodiode par exemple 7, montée entre une source +V et la terre à travers une résistance 8 qui transforme à nouveau le signal composite optique en un signal électrique composite contenant le signal utile et le signal pilote. Etant donné qu'il est admis que les atténuations subies par le signal pilote sont identiques à celles subies par le signal utile, le signal composite est appliqué à un amplificateur 9 à gain fixe suivi d'un atténuateur numérique 15, ensemble de circuits auquel est connecté un dispositif automatique de commande de gain, traitant le signal pilote qu'il a isolé et commandant l'atténuateur de façon que le signal utile qu'il délivre soit seul, soit encore mélangé au signal pilote ait le niveau requis.

Le dispositif de commande automatique du gain comprend à partir de l'amplificateur à gain fixe 9, un circuit filtre passe bande 10 isolant le signal pilote, un redresseur 11 sans seuil donnant le signal pilote sous forme d'une tension continue, un convertisseur analogique numérique 12 à plusieurs bits suivant la précision requise, un registre tampon 13 et un transcodeur 14. Celui-ci est connecté à l'atténuateur 15 dont il règle l'atténuation. Un filtre passe haut 16 connecté en sortie de l'atténuateur délivre en 17 le signal utile. Une horloge 18 ou programmateur est prévue pour commander le convertisseur 12, le registre tampon 13 et le transcodeur 14.

Dans ce dispositif relevant de l'art antérieur, on a précisé que le signal pilote ou signal de calibrage qui est superposé au signal utile pour donner le signal composite était situé en dehors de la bande signal utile. Le brevet français 2 361 022 décrit un système de ce genre dans lequel le signal de calibrage a un spectre situé en dehors du spectre du signal utile. Cependant étant donné qu'il est possible que la bande passante du signal utile s'étande depuis des fréquences voisines de zéro jusqu'à des fréquences pouvant atteindre plusiers centaines de mégaherts, il est nécessaire que le signal pilote doive être placé soit très bas en fréquence c'est-à-dire avant la fréquence utile la plus faible, soit très haut après la fréquence utile la plus haute. Ce choix risque de compliquer les circuits électroniques et limiter soit vers le haut, soit vers le bas la bande passante du signal utile. On peut alors choisir un signal de calibrage dont la fréquence se trouve dans le spectre de fréquence du signal utile et le transmettre à des instants où le signal utile n'est pas transmis, des moyens étant prévus pour éviter que les signaux utile et pilote se présentent ensemble dans la voie de transmission optique.

Dans un article de James C. Blackburn publié dans "I.E.E.E. Transactions on Instrumentation and Measurement", septembre 1975, vol IM 24, N° 3, intitulé "A 120 MHz Bandwidth Linear Signal Transmission System using Fiber Optics" une chaîne de traitement de signaux transmis par fibres optiques, fait état d'un signal de calibrage transmis "périodiquement" c'est-à-dire à des instants où le signal utile n'est pas transmis.

Le problème que vise alors à résoudre l'invention est d'assurer la transmission de signaux utiles pouvant transporter une grande énergie, sans qu'il en résulte une détérioration quelconque du système de transmission optique. Suivant l'invention on dérive une partie de cette énergie sur une voie optique dite dérivée, avec interruption de la transmission par la voie dite principale, le passage de l'énergie de la voie principale à la voie dérivée se faisant sur la commande d'un circuit appartenant au dispositif de contrôle du gain, appréciant l'augmentation dangereuse de l'énergie du signal utile.

D'autres avantages et caractéristiques de l'invention aparaîtront au cours de la description d'un exemple de réalisation donné à l'aide des figures qui représentent outre la figure 1:

— la figure 2 un diagramme schématique du système suivant l'invention, dans lequel le signal pilote est transmis périodiquement;

— les figures 3—1 à 3—10 des courbes représentatives des signaux en différents points du système.

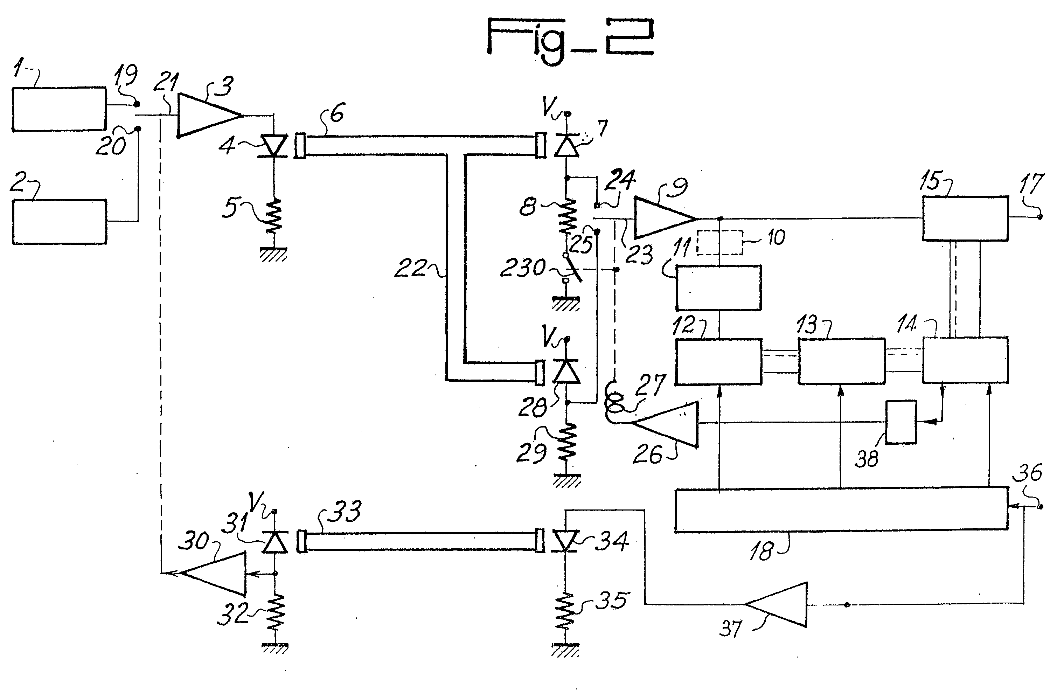

La figure 2 représente un réalisation d'un dispositif de contrôle automatique du gain d'une voie de réception dans un système utilisant une liaison optique. Ce dispositif est réalisé pour satisfaire à deux critères, fonctionner lorsque le signal pilote qui est associé au signal utile se trouve dans la bande passante du signal utile et principalement lorsque le signal utile transporte une grande énergie.

Dans la description de la figure 2, on conserve les références de la figure 1 pour les circuits qui se retrouvent occupant une même position dans l'ensemble et y remplissant les mêmes fonctions.

Le dispositif suivant l'invention comprend un capteur 1 du phénomène dont on veut étudier le signal, un générateur 2 du signal pilote qui est associé au signal utile dans des conditions qui seront définies plus loin, un modulateur 3, connectable, par le commutateur 21 et les plots 19—20, au capteur 1 ou au générateur du signal pilote et une diode d'émission 4, en série avec une résistance 5. Cette diode laser attaquée par le signal utile sous forme électrique issu du capteur 1, émet de l'énergie lumineuse dans une voie de liaison optique 6, par exemple une fibre optique d'un diamètre bien défini, dont la sortie attaque une photodiode 7. La fibre optique 6 comprend une dérivation sous la forme d'une fibre optique 22 qui prélève une partie bien définie de l'énergie transmise par la fibre 6. Cette fibre 22 attaque une autre photodiode 28.

Les sorties de ces photodiodes 7 et 28 sont connectées respectivement aux deux bornes 24, 25 d'un commutateur 23, connecté à un amplificateur 9 à gain fixe. Celui-ci est connecté d'une part à un redresseur 11 sans seuil, suivi d'un convertisseur analogique numérique 12 attaquant un registre tampon 13 et un transcodeur 14, alimentant à son tour un atténuateur à commande numérique 15 connectée d'autre également à l'amplificateur à gain fixe 9. L'atténuateur 15 est connecté à la sortie 17. Le transcodeur 14 comporte de plus une sortie particulière qui alimente à travers un comparateur 38 et un amplificateur 26, une bobine 27 du commutateur 23 et de l'interrupteur 230 inséré dans le circuit de sortie de la photodiode 7. Le commutateur 21 est commandé par un signal sortant du récepteur 30 connecté à la sortie d'une photodiode 31, placée à la sortie d'une liaison optique, constituée comme les précédentes par une fibre optique 33, dont l'entrée est soumise à l'action d'une diode d'émission 34, commandée à travers un amplificateur 37 par un ordre de calibrage 36. Cet ordre de calibrage est également appliqué à un circuit 18, un horloge qui contrôle le fonctionnement du convertisseur analogique 12, du registre 13 et du transcodeur 14.

Le système suivant l'invention est conçu pour accroître les possibilités du système de l'art antérieur en lui permettant de traiter des signaux utiles à grande énergie et de spectre étendu pouvant aller du côté des basses fréquences jusqu'à la fréquence 0, bande passante étendue qui est transmise sans problème particulier par la liaison optique choisie, dont l'influence principale, qu'il faut corriger, est une atténuation qui peut varier notablement au cours de l'exploitation. Un objet du brevet est ainsi la commande d'un circuit automatique du gain de la voie de réception du système décrit destinée à compenser, en numérique, les variations du signal reçu. On rappelle, que, suivant l'art antérieur. la commande de ce circuit était faite à l'aide d'un signal pilote ou de calibrage qui, situé en dehors de la bande passante du signal utile était transmis avec le signal utile. Dans les conditions de la figure 2 le signal pilote étant situé dans la bande du signal utile, il est apparu judicieux de le transmettre indépendamment du signal utile. Lorsque le signal utile n'est pas transmis de façon permanente, la transmission du signal de calibrage s'effectue à des instants où le signal utile n'est pas présent. Lorsque le signal utile est transmis de façon permanente, le signal de calibrage est transmis à des instants où le signal utile est volontairement occulté. La coupure dans le temps de la transmission du signal utile est de l'ordre de 10 à 20 ms, on peut admettre qu'elle n'est pas gênante.

On remarquera toutefois que le dispositif suivant l'invention tel que représenté figure 2, est toujours utilisable dans le cas où le signal utile est transmis de façon continue mais avec un spectre limité, entraînant la transmission de façon continue du signal de calibrage, celui-ci étant situé en dehors du spectre du signal utile. Il suffit d'insérer un filtre passe bande 10 entre l'amplificateur 9 et le circuit de redressement 11. Ce filtre est représente en traits interrompus.

Dans le cadre de l'exemple décrit suivant l'invention, la transmission du signal pilote ou de calibrage est effectuée périodiquement et de façon automatique. Pour ce faire, un signal de commande 36, dont la durée constitue la durée pendant laquelle l'opération de calibrage est exécutée (durée de l'ordre de 10 ms à plusieurs minutes, voire heures) est appliqué à l'amplificateur 37 et par la suite à la diode d'émission 34. Le signal 36 comme cela a été déjà indiqué est également appliqué à l'horloge 18 jouant le rôle d'un programmateur et permet de déclencher le fonctionnement du CAG numérique. Le signal lumineux émis par la diode 34 est transmis par une liaison optique 33, semblable à celle décrite dans l'art antérieur. L'énergie optique parcourant la fibre 33 est recueillie sur la photodiode 31 connectée à un récepteur 30. Celui-ci commande le commutateur 21 qui, par l'intermédiaire du plot 20, met en circuit le générateur 2 d'impulsions de calibrage. Le capteur 1 est alors mis hors circuit.

Dans ces conditions, le signal de calibrage est transmis à travers la chaîne comportant la liaison optique 6. On notera qu'en fonctionnement normal, l'interrupteur 230 est fermé et que le commutateur 23 se trouve sur le plot 24. Le signal de calibrage transformé en signal optique par la diode 4 est transmis par la liaison optique 6, où il subit l'atténuation provenant de la liaison elle-même, et retransformé par la photodiode 7 en un signal électrique qui, par la liaison 24—23 est appliqué à l'amplificateur à gain fixe 9. De là le signal dont on connait l'amplitude à l'origine, est appliqué au circuit 11 qui est un circuit redresseur sans seuil. Le signal pilote est ainsi redressé en conservant son amplitude et est appliqué à un circuit de conversion analogique numérique 12 qui délivre le signal de calibrage sous la forme d'un mot numérique à plusieurs bits suivant la précision recherchée. Ce mot est ensuite appliqué à un registre tampon 13 et à un transcodeur 14 modifiant si nécessaire le mot numérique qui lui est envoyé dans un code compatible avec la commande de l'atténuateur numérique 15. Ce circuit de transcodage est avantageusement constitué par une mémoire morte convenablement programmée dont l'adresse de lecture est constituée par la valeur numérique du signal de calibrage et dont le contenu est le mot binaire formé par les états logiques de commande de l'atténateur.

La figure 3 présente une série de courbes rendant compte des opérations qui ont été décrites ci-dessus.

La figure 3—1 représente le signal pilote ou de calibrage Sp qui est un signal sinusoïdal, transformé en une tension continue, suivant la figure 3—2 après passage dans le circuit de redressement sans seuil 11. La numérisation de ce signal de calibrage est commandée par une impulsion d'horloge H1 (figure 3—3) provenant par exemple du programmateur 18.

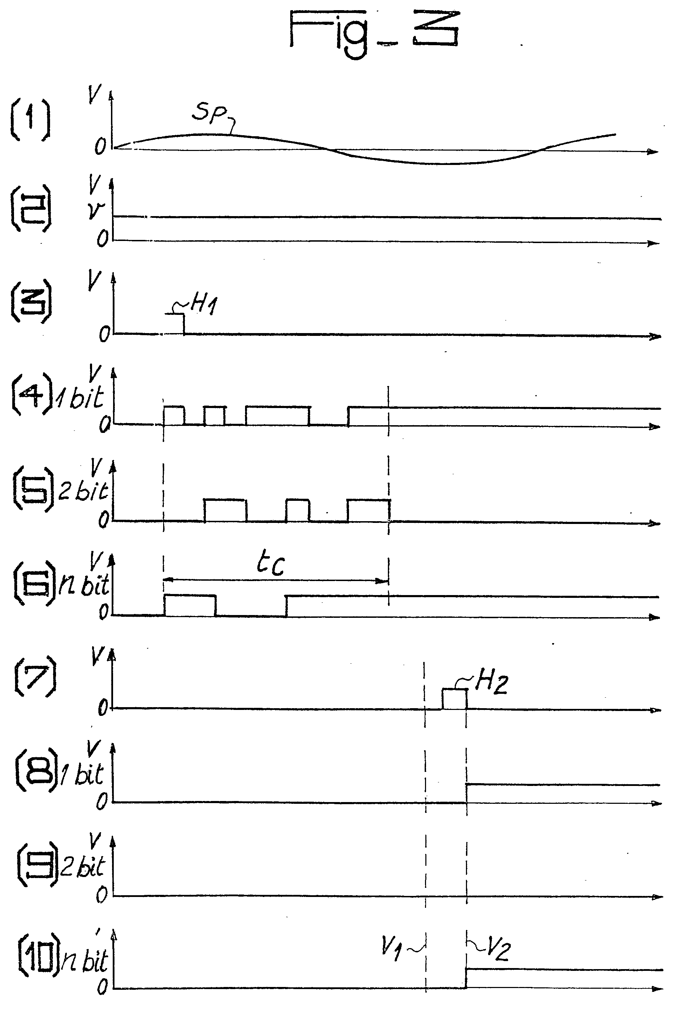

Les figures 3—3 à 3—6 représentent de façon schématique l'état des conducteurs de sortie du convertisseur 12 sur lesquels apparaissent les bits constitutifs du mot, après un temps tc pendant lequel s'est effectuée la conversion du signal analogique en son correspondant en numérique. La ligne verticale V1 marque la fin de l'opération de la conversion analogique numérique. Un signal d'horloge H2 (figure 3—7) provoque l'enregistrement du mot numérique représentant le signal de calibrage dans un registre tampon 13. Ce registre tampon peut être constitué par des bascules bistables qui sont ou non excitées suivant les niveaux de tension existant sur les sorties du convertisseur analogique numérique 12. Le transcodeur 14 connecté au registre tampon transforme le mot correspondant au signal de calibrage en un mot compatible avec la commande de l'atténuateur numérique 15. La ligne verticale V2 marque la prise en compte dans le registre tampon.

A titre d'exemple, l'atténuateur 15 peut comporter un nombre plus ou moins grand de cellules d'atténuation, pouvant être en T, constituées par des résistances.

Le signal de calibrage ayant réglé l'atténuateur 15, le commutateur 21 passe sur le plot 19, ouvrant la connexion avec le générateur 2 et mettant en circuit le capteur 1. Le signal délivré sous forme électrique par le capteur, emprunte le même circuit que décrit précédemment pour le signal de calibrage, c'est-à-dire passe par le modulateur 3, est transformé en signal optique par la diode électroluminescente 4, est transmis à travers la liaison optique 6, où il subit une atténuation propre à la liaison, est retransformé en signal électrique par la photodiode 7 placé à la sortie de la liaison, l'interrupteur 230 étant, aucune autre hypothèse n'étant faite, fermé, et est transmis par le commutateur 23, en contact avec la borne 24, à l'amplificateur 9 puis à l'atténuateur 15, réglé comme il vient d'être dit, qui délivre en 17 le signal utile.

Il est cependant des cas où le signal utile, transformé en un signal optique transporte une puissance très importante qui risque d'être dangereuse pour la photodiode de réception d'autant plus que le dispositif de contrôle automatique du gain est situé après la réception du signal utile par la photodiode. Il ne procure dans ce cas aucune protection.

Suivant l'invention, on protège la photodiode de réception 7 en provoquant une dérivation de la puissance optique disponible au niveau de la liaison, et en mettant hors circuit alors la photodiode concernée. On établit une dérivation sur la liaison optique 6, en soudant par exemple sur la fibre optique qui la constitue, une autre fibre optique, capable de transmettre une partie de la puissance globale. On crée ainsi une deuxième liaison optique semblable à la première, constituée par une seconde fibre 22, dont la sortie alimente une seconde photodiode 28, connectée à la masse à travers une résistance 29. La sortie de cette photodiode est connectée au deuxième plot 25 du commutateur 23. Le commutateur 23 ainsi que l'interrupteur 230 sont commandés par un même relais dont la bobine 27 est connectée à travers un amplificateur 26 au transcodeur 14.

Le fonctionnement de ce dispositif est le suivant. Lorsque le signal utile est à grande puissance, il est transmis tout d'abord comme un signal normal, par la voie de liaison principale 6, et jusqu'à l'amplificateur 9 à travers la photodiode 7 et le commutateur 23 qui a fermé le contract 24. Le signal de forte amplitude délivré à la sortie de l'amplificateur 9, est redréssé dans le circuit 11 et transformé en un mot numérique qui est reçu par le transcodeur. Le transcodeur est connecté à des moyens capables de déterminer si la valeur de la puissance transportée par le signal utile excède la valeur supportable par la photodiode 7. Ces moyens sont constitués par exemple par un comparateur 38 bit à bit qui compare le mot numérique à la sortie du transcodeur avec un mot de référence constituant la traduction de la limite de puissance optique acceptable par la voie principale et qui délivre un signal logique permanent quant cette limite est dépassée. Donc si la puissance transportée est supérieure à cette valeur limite, un signal est émis par le comparateur 38 qui excite le relais 27, provoquant l'ouverture de l'interrupteur 230 qui met hors circuit la photodiode 7 et fait passer le commutateur 23 du plot 24 au plot 25, connectant l'amplificateur à gain fixe 9 à la photodiode 28 associée à la liaison optique derivée 22. Celle-ci présente une atténuation déterminée par rapport à la voie principale 6, de sorte qu'elle transporte une énergie moindre que la puissance globale reçue par la liaison 6, énergie qui n'est pas dangereuse pour la photodiode 28.

On notera que cette façon de procéder pour établir une protection de la photodiode 7 est rendue possible par le fait que la dérivation est établie en un temps nettement inférieur à celui au bout duquel la photodiode est détruite qui est de l'ordre de 1 seconde alors que le temps de la commutation est de l'ordre de 10 ms.

On peut supposer par exemple que les atténuateurs variables 15 situés après l'amplificateur 9 permettent d'obtenir des atténuations allant de 0 à 15 dB par bonds de 1 dB. Ces atténuations correspondent à des atténuations optiques allant de 0 à 7,5 dB par bonds de 0,5 dB, car le signal optique provoque dans la photodiode un courant proportionnel à la puissance optique et toute variation de puissance optique exprimée en décibels se traduit par un nombre de décibels double au niveau du signal électrique.

On peut supposer également que la voie de dérivation présente une atténuation optique de l'ordre de 8 dB par rapport à la voie principale 6. Au début de l'exploitation lorsque la liaison est en bon état, la logique de décision, comparateur 38 connecté au transcodeur constatant que le signal utile reçu est trop fort, provoque la commutation de l'amplificateur 9 sur le plot 25 et donc sur la voie dérivée, transmettant un signal optique situé à 8 dB plus bas que le signal utile à l'entrée de la voie 6. Le signal de calibrage issu du générateur 2, provoque, de la façon qui a été décrite, le réglage de l'atténuation des atténuateurs 15 et après ce réglage, la fraction du signal utile délivrée par la photodiode 28 est traitée de la façon qui a été déjà décrite.

Il peut se faire qu'après exploitation, le signal optique reçu se dégrade, pour des raisons diverses, pouvant par exemple venir du vieillissement de la liaison ou de la mauvaise qualité intrinsèque de cette liaison et subisse une atténuation de l'ordre de 8 dB. Cette atténuation est perçue par le comparateur 38, qui supprimant le signal d'excitation de la bobine 27 du relais, provoque la fermeture de l'interrupteur 230 remettant en circuit la photodiode 7 et fait passer le commutateur 23 sur le plot 24. Le signal utile est dans ces conditions à nouveau transmis par la voie principale 6.

L'atténuation de la voie secondaire par rapport à la voie principale peut être située dans l'exemple précédent à toutes valeurs inférieures à 8 dB. Dans ce cas, on obtient un recouvrement des deux gammes. Si par exemple, la voie dérivée se situe à 5 dB pour certaines valeurs d'atténuation sur la liaison optique, la logique de décision a le choix entre utiliser la voie principale et atténuer fortement en électrique ou utiliser la voie secondaire et atténuer faiblement en électrique. La plage de fonctionnement la plus large est toutefois obtenue pour une valeur quasi identique des deux atténuations, l'atténuation optique étant égale à l'atténuation électrique maximale plus un pas de quantification de l'atténuateur électrique 0,5 dB dans l'exemple décrit.

La division de puissance entre les deux voies peut aussi être réalisée en deux parties identiques. Cette solution est toutefois moins performante, le signal optique étant dans ce cas affaibli de moitié par rapport à solution sans division de voies. La division du signal optique en deux parties de valeur inégale permet de conserver la quasi totalité de la puissance optique sur la voie principale et donc de préserver les performances dans le cas le plus défavorable où l'atténuation optique sur la ligne est maximale.

On a ainsi décrit un dispositif de contrôle automatique du gain d'une voie de réception, inclue dans un système comportant des liaisons optiques qui peuvent soumises à des signaux transport une grande énergie. On notera que le dispositif de contrôle automatique agit avant l'atténuateur 15. L'enseignement suivant l'invention s'applique également lorsque le dispositif de contrôle automatique est connecté derrière l'atténuateur. Il comporte simplement en plus une mémoire introduite entre le transcodeur et l'atténuateur qui emmagasine l'état précédent de l'atténuateur dont il faut tenir compte.

## Revendications

1. Système de transmission de signaux électriques à liaison optique (6) avec un dispositif de contrôle automatique (9 à 18) du gain d'une voie de réception connectée à la sortie de cette liaison, le dispositif de contrôle étant commandé par un signal pilote de niveau connu, ledit signal pilot se trouvant, soit dans le spectre du signal utile de niveau in connu et étant alors transmis lors d'interruptions périodiques du signal utile, soit à l'extérieur du spectre du signal utile de niveau inconnu à étant alors transmis simultanément avec le signal utile, caractérisé en ce que la liaison optique comporte une liaison optique dite dérivée (22) apportant un affaiblissement supérieur à celui de la liaison dite principale (6) à laquelle elle est raccordée cette liaison dérivée (22) étant mise en service lorsque le signal utile transmis dépasse un seuil d'énergie prédéterminé mis en évidence dans un comparateur (38) commandant un commutateur (23) ouvrant la connexion de la voie principale (6, 7) à l'amplificateur d'entrée (9) du dispositif de contrôle et établissant la connexion de la voie dérivée (22, 28) à cet amplificateur.

2. Système de transmission suivant la revendication 1, avec un dispositif de contrôle automatique du gain comprenant, connectée en sortie de l'amplificateur (9) de la voie de réception, un circuit de redressement (11) sans seuil, un circuit de conversion (12) analogique-numérique, transformant le signal analogique que délivre le circuit de redressement, en un mot binaire, un registre tampon (13), un transcodeur (14) et un circuit d'atténuation (15) dont il règle la valeur, caractérisé en ce qu'il comprend une logique dite de décision (38), comparant le signal de sortie du transcodeur (14) avec un signal seuil définissant le niveau tolérable par la liaison dite principale (6—7).

3. Système de transmission suivant l'une ou l'autre des revendications 1 et 2, caractérisé en ce qu'il comporte un dispositif de commande (27) du commutateur (23), excité par la logique de décision (38) lorsque la valeur du signal utile délivré par le transcodeur (14) dépasse une valeur prédéterminée, l'excitation du dispositif de commande (27) provoquant outre la connexion de l'amplificateur d'entrée (9) de la voie de réception au dispositif de sortie (28) de la liaison optique dérivée (22), l'ouverture d'un interrupteur (230) placé dans le dispositif de sortie (7) de la liaison optique principale (6).

4. Système de transmission suivant la revendication 3, caractérisé en ce que le dispositif de sortie (7) de la liaison optique principale (6) est une photodiode et que l'interrupteur (230) est introduit dans son circuit de charge comprenant une résistance (8).

5. Système de transmission suivant la revendication 1, caractérisé en ce qu'il comprend une horloge intégrée ou programmateur (18) commandant le fonctionnement des circuits de conversion analogique-numérique (12) du registre tampon (13) et du transcodeur (14).

6. Système de transmission suivant l'une des revendications 1 et 5, dans lequel le signal pilote est transmis périodiquement, comprenant un commutateur (21) connecté périodiquement au capteur (1) délivrant le signal utile ou au générateur (2) du signal pilote, caractérisé en ce que le dispositif de commande (30) dudit commutateur (21) est déclenché par une commande (36), le signal de commande étant transmis à travers une liaison optique (33) comportant un dispositif d'entrée (34) du type électroluminescent et un dispositif de sortie (31) du type photodiode.

7. Système de transmission suivant la revendication 6, caractérisé en ce que le signal de commande (36) est appliqué également au programmateur (18).

8. Système de transmission suivant les revendications 1 et 6, caractérisé en ce que les liaisons optiques sont constituées par des fibres optiques, à un seul conducteur, la fibre optique principale (6) comportant en dérivation une autre fibre optique (22) qui lui est soudée.

9. Système de transmission suivant la revendication 1, caractérisé en ce qu'il est à large bande passante, pouvant inclure la fréquence zéro.

## Claims

1. System for transmission of electric signals by an optic connection (6), comprising an automatic gain control device (9 to 18) for controlling the gain of a reception path connected to the output of said connection, the control device being controlled by a pilot signal of known level, said pilot signal being either within the spectrum of the useful signal of known level and, in this case, being transmitted during periodic interruptions of the useful signal, or outside the spectrum of the useful signal of unknown level, and, in that case, being transmitted simultaneously with the useful signal, characterized in that the optic connection comprises an optic connection termed as derived optic connection (22) causing an attenuation larger than that of the connection termed as the main connection (6) to which it is connected, said derived connection (22) being made operative when the transmitted useful signal exceeds a predetermined energy threshold as evidenced in a comparator (38) controlling a switch (23) opening the connection of the main path (6, 7) with the input amplifier (9) of the control device and establishing the connection of the derived path (22, 28) with the amplifier.

2. Transmission system in accordance with claim 1, including an automatic gain control device comprising, series-connected to the output of the amplifier (9) of the reception path, a thresholdless rectifier circuit (11), an analog-digital converter circuit transforming the analog signal delivered by the rectifier circuit into a binary word, a buffer register (13), a transcoder (14) and an attenuation circuit (15) of which it regulates the value, characterized in that it comprises a logic termed as a decision logic (38) comparing the output signal of the transcoder (14) with a threshold signal defining the level tolerated by the main connection (6, 7).

3. Transmission system in accordance with any of claims 1 and 2, characterized in that it comprises a control device (27) of the switch (23) excited by the decision logic (38) when the value of the useful signal delivered by the transcoder (14) exceeds a predetermined value, the excitation of the control device (27) causing, in addition to the connection of the input amplifier (9) of the reception path to the output device (28) of the derived optic connection (22), the opening of an interrupter (230) located in the output device (7) of the optic main connection (6).

4. Transmission system in accordance with claim 3, characterized in that the output device (7) of the optic main connection (6) is a photodiode and the interrupter (230) is inserted into its load circuit comprising a resistor (8).

5. Transmission system in accordance with claim 1, characterized in that it comprises an integrated clock or programmer (18) controlling the operation of the analog-digital converter circuit (12), of the buffer register (13) and of the transcoder (14).

6. Transmission system in accordance with any of claims 1 and 5, in which the pilot signal is periodically transmitted, comprising a switch periodically connected to the sensor (1) delivering the useful signal or to the pilot signal generator (2), characterized in that the control device (30) of the switch (21) is triggered by a control (36), the control signal being transmitted through an optic connection (33) comprising an input device (34) of electroluminescent type and an output device (31) of photodiode type.

7. Transmission system in accordance with claim 6, characterized in that the control signal (36) is also connected to the programmer (18).

8. Transmission system in accordance with claims 1 and 6, characterized in that the optic connections are formed by optic fibres having a single conductor, the optic main fibre (6) comprising another, derived optic fibre (22) welded thereto.

9. Transmission system in accordance with claim 1, characterized in that it is of large band type eventually including a zero frequency.

## Patentansprüche

1. System zur Übertragung von elektrischen Signalen über eine optische Verbindung (6), mit einer Vorrichtung (9 bis 18) zur automatischen Regelung der Verstärkung eines Empfangskanals, der an den Ausgang dieser Verbindung angeschlossen ist, wobei die Regelvorrichtung durch ein Pilotsignal bekannten Pegels gesteuert wird, wobei sich dieses Pilotsignal entweder im Nutzsignalspektrum bekannten Pegels befindet und dann während periodischen Unterbrechungen des Nutzsignals übertragen wird, oder außerhalb des Spektrums des Nutzsignals unbekannten Pegels befindet und dann gleichzeitig mit dem Nutzsignal übertragen wird, dadurch gekennzeichnet, daß die optische Verbindung eine als abgezweigte optische Verbindung bezeichnete optische Verbindung (22) enthält, die eine stärkere Absenkung hervorruft als die als Hauptverbindung bezeichnete Verbindung (6), an die sie angeschlossen ist, wobei diese abgezweigte Verbindung (22) in Betrieb genommen wird, wenn das übertragene Nutzsignal eine vorbestimmte Energieschwelle überschreitet, die in einem Komparator (38) offenbar wird, der einen Schalter (23) steuert, welcher die Verbindung des Hauptkanals (6, 7) mit dem Eingangsverstärker (9) der Regelvorrichtung öffnet und die Verbindung des Zweigkanals (22, 28) mit diesem Verstärker herstellt.

2. Übertragungssystem nach Anspruch 1, mit einer automatischen Verstärkungsregelschaltung, die an den Ausgang des Verstärkers (9) des Empfangskanals angeschlossen eine schwellenlose Gleichrichterschaltung (11), eine Analog/Digital-Umsetzschaltung (12), die das von der Gleichrichterschaltung abgegebene Analogsignal in ein Binärwort umwandelt, ein Pufferregister (13), einen Transcoder (14) und eine Dämpfungsschaltung (15), deren Wert es regelt, enthält, dadurch gekennzeichnet, daß es eine als Entscheidungslogik bezeichnete Logik (38) enthält, die das Ausgangssignal de Transcoders (14) mit einem Schwellsignal vergleicht, das den von der Hauptverbindung (6, 7) tolerierten Pegel definiert.

3. Übertragungssystem nach Anspruch 1 oder 2, dadurch gekennzeichnet, daß es eine Vorrichtung (27) zur Steuerung des Schalters (23) enthält, die von der Entscheidungslogik (38) erregt wird, wenn der Wert des von dem Transcoder (14) gelieferten Nutzsignals einen vorbestimmten Wert überschreitet, wobei die Erregung der Steuervorrichtung (27) außer der Verbindung des Eingangsverstärkers (9) des Empfangskanals mit der Ausgangsvorrichtung (28) der abgezweigten optischen Verbindung (22) das Öffnen eines Unterbrechers (230) hervorruft, der in der Ausgangsvorrichtung (7) der optischen Hauptverbindung (6) angeordnet ist.

4. Übertragungssystem nach Anspruch 3, dadurch gekennzeichnet, daß die Ausgangsvorrichtung (7) der optischen Hauptverbindung (6) eine Photodiode ist und der Unterbrecher (230) in ihren Lastkreis eingefügt ist, der einen Widerstand (8) enthält.

5. Übertragungssystem nach Anspruch 1, dadurch gekennzeichnet, daß es einen integrierten Taktgeber oder Programmierer (18) enthält, der den Betrieb der Analog/Digital-Umsetzschaltungen (12), des Pufferregisters (13) und des Transcoders (14) steuert.

6. Übertragungssystem nach einem der Ansprüche 1 und 5, bei welchem das Pilotsignal periodisch übertragen wird, mit einem Schalter (21), der periodisch an den das Nutzsignal abgebenden Fühler (1) oder an den Pilotsignalgenerator (2) angekoppelt wird, dadurch gekennzeichnet, daß die Steuervorrichtung (30) des Schalters (21) durch eine Steuerung (36) ausgelöst wird, wobei das Steuersignal über eine optische Verbindung (33) übertragen wird, die eine Eingangsvorrichtung (34) vom Elektrolumineszenztyp und eine Ausgangsvorrichtung (31) vom Photodiodentyp enthält.

7. Übertragungssystem nach Anspruch 6, dadurch gekennzeichnet, daß das Steuersignal (36) auch an den Programmierer (18) angelegt wird.

8. Übertragungssystem nach den Ansprüchen 1 und 6, dadurch gekennzeichnet, daß die optischen Verbindungen durch optische Fasern mit einem einzigen Leiter gebildet sind, wobei die optische Hauptfaser (6) eine daran geschweißte, abgezweigte weitere optische Faser (22) enthält.

9. Übertragungssystem nach Anspruch 1, dadurch gekennzeichnet, daß es breitbandig, ggf. einschließlich der Nullfrequenz, ausgebildet ist.

*Fig_1*

ART ANTERIEUR

0 004 815

Fig_2

0004 815

Fig_3